# EUROPEAN PATENT APPLICATION

(11) **EP 4 768 972 A1**
(43) Date of publication of application: **01.07.2026**
(21) Application number: 25783070.3
(22) Date of filing: 20.03.2025
(51) Int. Cl.: G01R 31/396, G01R 31/385, G01R 19/30, G01R 19/10, G01R 19/165, G01R 31/392, G01R 31/371, H01M 10/48

(54) **BATTERY DIAGNOSIS APPARATUS AND BATTERY DIAGNOSIS METHOD**

(30) Priority: 03.04.2024 KR 20240045416
(71) Applicant: LG Energy Solution, Ltd., Seoul 07335 (KR)
(72) Inventor: KU, Eun Bi, Daejeon 34122 (KR)
(74) Representative: Goddar, Heinz J.
(86) International application number: PCT/KR2025/095017
(87) International publication number: WO 2025/211894

(57) **Abstract**

According to some embodiments, a battery diagnosis device includes an interface configured to acquire battery data from a diagnosis target battery for each collection interval when a current cycle is initiated and a controller configured to determine whether the battery data passes test items for each collection interval and generate a first count value of the current cycle, accumulate a number of times the determination of the test items fails in the current cycle and generate a second count value of the current cycle, perform a first diagnosis on the diagnosis target battery based on a first accumulated value of the first count value for a first number of cycles, and perform a second diagnosis on the diagnosis target battery based on a second accumulated value of the second count value for a second number of cycles.

## Description

### TECHNICAL FIELD

### Cross-reference to Related Applications

This application claims priority from Korean Patent Application No. 10-2024-0045416, filed on April 3, 2024, the disclosure of which is incorporated by reference herein.

### Technical Field

Embodiments disclosed herein relate to a battery diagnosis device and a battery diagnosis method.

### BACKGROUND ART

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium ion batteries. Among secondary batteries, lithium ion batteries may have a higher energy density than conventional Ni/Cd batteries, Ni/MH batteries, or the like, and may be manufactured to be small and lightweight, so the lithium ion batteries may have high usability as a power source for mobile devices. In recent years, the lithium ion batteries have expanded their range of use to power sources for electric vehicles, making the batteries attract attention as a next-generation energy storage medium.

In order to prevent battery accidents due to overheating, a battery management system (BMS) may detect signs of thermal abnormalities and warn a vehicle and a driver. For example, a battery voltage and a battery temperature may be measured and early warning of thermal events may be performed based on the measured result. In cases where battery data collection is unstable due to a communication state with the BMS, overheating event tests are performed with limited data. In cases of such poor data collection, degradation of the accuracy of overheating diagnosis may become a problem.

### DISCLOSURE OF THE INVENTION

### TECHNICAL PROBLEM

An object of the embodiments disclosed herein is to provide a battery diagnosis device and a battery diagnosis method capable of diagnosing an overheating event more accurately even when collection of battery data is poor due to an unstable communication state.

The technical objectives of the embodiments disclosed herein are not limited to those mentioned above, and other technical objectives not mentioned will be clearly understood by those skilled in the art from the following descriptions.

### TECHNICAL SOLUTION

According to some embodiments, a battery diagnosis device includes an interface configured to acquire battery data from a diagnosis target battery for each collection interval when a current cycle is initiated and a controller configured to determine whether the battery data passes test items for each collection interval and generate a first count value of the current cycle, accumulate a number of times the determination of the test items fails in the current cycle and generate a second count value of the current cycle, perform a first diagnosis on the diagnosis target battery based on a first accumulated value of the first count value for a first number of cycles, and perform a second diagnosis on the diagnosis target battery based on a second accumulated value of the second count value for a second number of cycles.

According to some embodiments, the diagnosis target battery may include a plurality of battery cells, and the battery data may include a cell voltage and a cell temperature of each of the plurality of battery cells.

According to some embodiments, the test items may include a first item regarding whether a maximum cell voltage exceeds a cell voltage upper limit, a second item regarding whether a minimum cell voltage is less than a cell voltage lower limit, a third item regarding whether a cell voltage deviation with respect to an average cell voltage exceeds a voltage deviation threshold, a fourth item regarding whether a maximum cell temperature exceeds a cell temperature upper limit, and a fifth item regarding whether a cell temperature deviation with respect to an average cell temperature exceeds a temperature deviation threshold.

According to some embodiments, the controller may be configured to determine a detailed count value for each of the test items for each collection interval, check, among the test items, a test item whose detailed count value exceeds a threshold count of each of the test items as defective in the current cycle, and perform the first diagnosis based on the number of defects of the test items for the first number of cycles up to the current cycle.

According to some embodiments, the controller may be configured to perform the first diagnosis when there is a test item that is checked as defective in all of the first number of cycles among the test items.

According to some embodiments, the controller may be configured to perform the second diagnosis when the second accumulated value of the second count value for the second number of cycles exceeds a second diagnosis threshold of each of the test items.

According to some embodiments, the second number of cycles may be greater than the first number of cycles and the second diagnosis threshold of each of the test items may be a product of the threshold count of each of the test items and the first number of cycles.

According to some embodiments, the controller may be configured to change a state of the diagnosis target battery to a thermal event early alarm state based on at least one of the first diagnosis and the second diagnosis.

According to some embodiments, a battery diagnosis method includes collecting battery data from a diagnosis target battery for each collection interval when a current cycle is initiated, determining whether the battery data passes test items for each collection interval and generating a first count value of the current cycle, accumulating a number of times the determination of the test items fails in the current cycle and generating a second count value of the current cycle, performing a first diagnosis on the diagnosis target battery based on a first accumulated value of the first count value for a first number of cycles, and performing a second diagnosis on the diagnosis target battery based on a second accumulated value of the second count value for a second number of cycles.

According to some embodiments, the diagnosis target battery may include a plurality of battery cells, and the battery data may include a cell voltage and a cell temperature of each of the plurality of battery cells.

According to some embodiments, the test items may include a first item regarding whether a maximum cell voltage exceeds a cell voltage upper limit, a second item regarding whether a minimum cell voltage is less than a cell voltage lower limit, a third item regarding whether a cell voltage deviation with respect to an average cell voltage exceeds a voltage deviation threshold, a fourth item regarding whether a maximum cell temperature exceeds a cell temperature upper limit, and a fifth item regarding whether a cell temperature deviation with respect to an average cell temperature exceeds a temperature deviation threshold.

According to some embodiments, the performing of the first diagnosis may include determining a detailed count value for each of the test items for each collection interval, checking, among the test items, a test item whose detailed count value exceeds a threshold count of each of the test items as defective in the current cycle, and performing the first diagnosis based on the number of defects of the test items for the first number of cycles up to the current cycle.

According to some embodiments, the performing of the first diagnosis may include performing the first diagnosis when there is a test item that is checked as defective in all of the first number of cycles among the test items.

According to some embodiments, the performing of the second diagnosis may include performing the second diagnosis when the second accumulated value of the second count value for the second number of cycles exceeds a second diagnosis threshold of each of the test items.

According to some embodiments, the second number of cycles may be greater than the first number of cycles and the second diagnosis threshold of each of the test items may be a product of the threshold count of each of the test items and the first number of cycles.

According to some embodiments, the battery diagnosis method may further include changing a state of the diagnosis target battery to a thermal event early alarm state based on at least one of the first diagnosis and the second diagnosis.

### ADVANTAGEOUS EFFECTS

According to the embodiments disclosed herein, a battery diagnosis device and a battery diagnosis method capable of diagnosing an overheating event more accurately even when collection of battery data is poor due to an unstable communication state can be provided.

The technical effects according to the embodiments disclosed herein are not limited to those mentioned above, and other effects not mentioned will be clearly understood by those skilled in the art from the disclosure herein.

### BRIEF DESCRIPTION OF THE DRAWINGS

FIG. 1 may illustrate elements that constitute a battery diagnosis system according to some embodiments.
FIG. 2 may illustrate elements constituting the battery diagnosis device according to some embodiments.
FIG. 3 may illustrate a process of performing an early alarm for a thermal event through a first diagnosis and a second diagnosis according to some embodiments.
FIG. 4 may illustrate detection criteria and detailed count values of test items according to some embodiments.
FIG. 5 may illustrate a form in which count values for a cell high voltage test change as cycles progress according to some embodiments.
FIG. 6 may illustrate steps of a battery diagnosis method according to some embodiments.

### MODE FOR CARRYING OUT THE INVENTION

Hereinafter, embodiments disclosed in herein will be described with reference to the accompanying drawings. However, this is not intended to limit the disclosure herein to the specific embodiments, and it is to be construed to include various modifications, equivalents, and/or alternatives of embodiments disclosed herein.

It should be appreciated that embodiments herein and the terms used therein are not intended to limit the technological features set forth herein to particular embodiments and include various changes, equivalents, or replacements for a corresponding embodiment. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st," "2nd," "first," "second," "A," "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory and CD-ROM), or be distributed (e.g., downloaded or uploaded) online via an application store, or between two operator devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

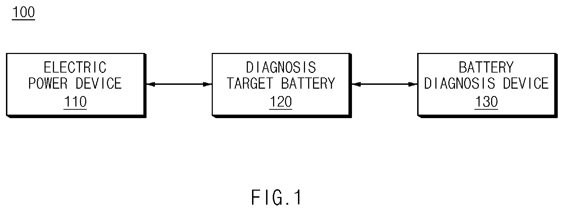

FIG. 1 may illustrate elements constituting a battery management system according to some embodiments.

Referring to FIG. 1, a battery diagnosis system 100 may include an electric power device 110, a diagnosis target battery 120, and a battery diagnosis device 130. However, the battery diagnosis system is not limited thereto, and some components may be omitted from the battery diagnosis system 100, or other general-purpose components may be further included in the battery diagnosis system 100.

The battery diagnosis system 100 may refer to a system for diagnosing the diagnosis target battery 120 and managing its state. When the diagnosis target battery 120 is charged or discharged by the electric power device 110, the battery data of the diagnosis target battery 120 may be measured and analyzed by the battery diagnosis device 130.

The electric power device 110 may be configured to charge or discharge the diagnosis target battery 120. The electric power device 110 may discharge the diagnosis target battery 120 while consuming electric power, and may charge the diagnosis target battery 120 while generating electric power. According to an embodiment, the electric power device 110 may include a mobility device such as an electric vehicle (EV), a hybrid electric vehicle (HEV), an electric bike, or the like. The mobility device may drive a motor based on electric power from the diagnosis target battery 120 or charge the diagnosis target battery 120 with electric power generated through regenerative braking.

The diagnosis target battery 120 may include a battery pack or the like to be diagnosed by the battery diagnosis system 100. The battery pack of the diagnosis target battery 120 may include a plurality of battery modules, and each battery module may include a plurality of battery cells. According to an embodiment, the diagnosis target battery 120 may be mounted on various types of mobility devices.

The battery diagnosis device 130 may perform operations for diagnosing or managing the diagnosis target battery 120. The battery diagnosis device 130 may measure battery data from the diagnosis target battery 120 and diagnose or manage the state of the diagnosis target battery 120 based on the battery data.

The battery diagnosis system 100 may further include a management server. The management server may manage diagnosis results of the battery diagnosis device 130. The management server may exchange data with the battery diagnosis device 130 via wired/wireless communication. When a defect in the diagnosis target battery 120 is diagnosed or its lifespan is predicted, the results may be transmitted to the management server and recorded in a database.

According to an embodiment, the management server may perform operations for managing the diagnosis target battery 120 in place of the battery diagnosis device 130. According to an embodiment, the operations of the battery diagnosis device 130 may be performed by a charging device of a battery charging station. According to an embodiment, the battery diagnosis device 130 may perform diagnostic operations by executing battery management software, and the management server may provide update information about the battery management software to the battery diagnosis device 130.

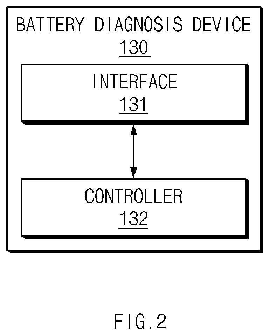

FIG. 2 may illustrate elements constituting the battery diagnosis device according to some embodiments.

Referring to FIG. 2, the battery diagnosis device 130 may include an interface 131 and a controller 132. However, the battery diagnosis device is not limited thereto, and some components may be omitted from the battery diagnosis device 130, or other general-purpose components may be further included in the battery diagnosis device 130.

The battery diagnosis device 130 may be a battery management system (BMS) configured together with the diagnosis target battery 120 in an on-board form, or the battery diagnosis device 130 may be an external device configured remotely with the diagnosis target battery 120 in an off-board form. According to an embodiment, the external device may include a battery management server, a battery diagnosis device, a battery charging device, and the like. The battery management server may include a cloud server operating in a cloud computing environment. According to an embodiment, the interface 131 and the controller 132 in the battery diagnosis device 130 may be electrically connected to each other through a device-to-device communication method. The device-to-device communication method may include a bus, a general purpose input and output (GPIO), a serial peripheral interface (SPI), and a mobile industry processor interface (MIPI).

The interface 131 may acquire battery data of the diagnosis target battery 120. According to an embodiment, the interface 131 may include at least one of a communication unit configured to receive battery data and a sensor unit configured to measure battery data. According to an embodiment, when the battery diagnosis device 130 is implemented in an off-board form, the communication unit may receive battery data in a manner such as wired data communication, wireless data communication, or the like. Alternatively, when the battery diagnosis device 130 is implemented in the on-board form, the sensor unit may be configured to generate various battery measured values from the diagnosis target battery 120. To this end, the sensor may include measuring means such as a voltage sensor, a current sensor, and a temperature sensor.

The controller 132 may have a structure for executing commands that implement operations of the battery diagnosis device 130. The controller 132 may be implemented as an array of a number of logic gates for processing various operations or as a general-purpose microprocessor, and may consist of a single processor or a plurality of processors. For example, the controller 132 may be implemented in the form of at least one of a microprocessor, a central processing unit (CPU), a graphics processing unit (GPU), and an application processor (AP).

The controller 132 may operate together with a memory configured to store various data, commands, mobile applications, computer programs, and the like. The memory may be configured separately from or integrally with the controller 132. The controller 132 may process various operations by executing commands stored in the memory. The memory may be implemented in a form of a non-volatile device such as a read-only memory (ROM), a programmable ROM (PROM), an erasable programmable ROM (EPROM), an electrically erasable PROM (EEPROM), a flash memory, a parallel random-access memory (PRAM), a magneto-resistive RAM (MRAM), a resistive RAM (RRAM), a ferroelectric RAM (FRAM), or the like, or a volatile device such as a dynamic RAM (DRAM), a static RAM (SRAM), a synchronous dynamic RAM (SDRAM), a parallel RAM (PRAM), or the like, or may be implemented in a form of a hard disk drive (HDD), a solid state drive (SSD), a secure digital (SD), Micro-SD, or a combined form thereof.

The interface 131 may be configured to acquire battery data from the diagnosis target battery 120 at each collection interval once a current cycle has been initiated. The current cycle may be a drive cycle such as an electric vehicle (EV) or the like. The battery data may be collected during each collection interval of the current cycle. For example, the collection interval may be 1 second, or other appropriate values may be used depending on the design.

The controller 132 may be configured to determine whether the battery data passes test items at each collection interval and generate a first count value of the current cycle. For example, the battery data may include a cell voltage and a cell temperature, test items may include 5 items, and the collection interval may be 1 second. Every second, a determination as to whether any of the five items fail the test may be made, and that data may be recorded. For example, the current cycle may last for 30 minutes, and the first count value may be calculated based on the number of failed test items.

The controller 132 may be configured to accumulate, in the current cycle, the number of times the determination of the test items fails and to generate a second count value of the current cycle. Determining the test items may fail due to various reasons, such as internal defects in the diagnosis target battery 120, malfunctions in the interface 131, poor communication of the battery diagnosis device 130, or the like. Since the determination failure may lead to a missed opportunity for defect diagnosis, the second count value may be generated based on the number of determination failures for overheating diagnosis taking this into account.

The controller 132 may be configured to perform a first diagnosis on the diagnosis target battery 120 based on a first accumulated value of the first count value for the first number of cycles. The first accumulated value of the first count value may indicate how many of the test items pass or fail, which may indicate an overheating risk of the diagnosis target battery 120. For example, the first number of cycles may be 5, which may include four past cycles and one current cycle. The specific number of the first number of cycles may vary depending on diagnostic accuracy requirements.

The controller 132 may be configured to perform a second diagnosis on the diagnosis target battery 120 based on a second accumulated value of the second count value for a second number of cycles. A higher second accumulated value of the second count value may indicate more data collection failures, which may mean that the risk of missing overheating diagnoses is increased. By reflecting this, the second diagnosis based on the second accumulated value may be performed. For example, the second number of cycles may be 10, and may be changed to other values depending on the design. The second number of cycles may be greater than the first number of cycles.

According to an embodiment, the diagnosis target battery 120 may include a plurality of battery cells, and the battery data may include a cell voltage and a cell temperature of each of the plurality of battery cells. Battery diagnostic indicators may be derived based on the cell voltage and the cell temperature of each battery cell, and a determination as to whether test items pass or fail may be made based on the battery diagnostic indicators. The battery diagnostic indicators may include a maximum cell voltage, a minimum cell voltage, a cell voltage deviation with respect to an average cell voltage, a maximum cell temperature, and a cell temperature deviation with respect to an average cell temperature, and the like.

According to an embodiment, the test items may include a first item regarding whether the maximum cell voltage exceeds a cell voltage upper limit, a second item regarding whether the minimum cell voltage is less than a cell voltage lower limit, a third item regarding whether the cell voltage deviation with respect to the average cell voltage exceeds a voltage deviation threshold, a fourth item regarding whether the maximum cell temperature exceeds a cell temperature upper limit, and a fifth item regarding whether the cell temperature deviation with respect to the average cell temperature exceeds a temperature deviation threshold. The test items may be monitored to diagnose an overheating event of the diagnosis target battery 120.

According to an embodiment, the controller 132 may be configured to determine a detailed count value for each of the test items for each collection interval, check, among the test items, a test item whose detailed count value exceeds a threshold count of each of the test items as defective in the current cycle, and perform the first diagnosis based on the number of defects of the test items for the first number of cycles up to the current cycle. When the collection interval is one second and there are five test items, a determination as to whether the test for the five items passes or fails may be made every second. For example, when the number of times the test for a test item fails during the current cycle of 30 minutes is 25, the detailed count value of the test item may be 25. When the threshold count of the first test item is 20, since the detailed count value exceeds the threshold count, the first test item may be checked as defective in the current cycle. The first diagnosis may be performed based on the accumulated number of defects for five items during the first number of cycles.

According to an embodiment, the controller 132 may be configured to perform the first diagnosis when there is a test item that is checked as defective in all of the first number of cycles among the test items. For example, the first number of cycles may be 5, which may include four past cycles and one current cycle. When any one of the five test items is checked as defective in all five cycles, the first diagnosis may be performed on the diagnosis target battery 120, which may indicate that the diagnosis target battery 120 is at risk of an overheating event.

According to an embodiment, the controller 132 may be configured to perform the second diagnosis when the second accumulated value of the second count value for the second number of cycles exceeds a second diagnosis threshold for each of the test items. For example, the second number of cycles may be 10, and the second count value may be accumulated for 10 cycles. The second accumulated value may be generated for each of the test items. For example, when there are five second accumulated values for five test items, the five second accumulated values may be compared with the five second diagnosis thresholds, respectively. Among the five test items, when there is a test item whose second accumulated value exceeds the second diagnosis threshold, the second diagnosis may be performed on the diagnosis target battery 120. The second diagnosis may indicate that the diagnosis target battery 120 is at risk of overheating due to missing data collection.

According to an embodiment, the second number of cycles is greater than the first number of cycles, and the second diagnosis threshold of each of the test items may be the product of the threshold count of each of the test items and the first number of cycles. The threshold count and the first number of cycles may be used for the first diagnosis, while the second diagnosis threshold may be used for the second diagnosis. By setting the second diagnosis threshold as the product of the threshold count and the first number of cycles, parameters of the first diagnosis and parameters of the second diagnosis may be correlated with each other. This allows the risk of overheating due to failure to pass the test items and the risk of overheating due to poor data collection to be associated with each other.

According to an embodiment, the controller 132 may be configured to change the state of the diagnosis target battery 120 to a thermal event early alarm state based on at least one of the first diagnosis and the second diagnosis. Since the thermal event early alarm state reflects both the first and second diagnoses, the overheating risk due to the failure to pass the test item and the overheating risk due to poor data collection may be considered together.

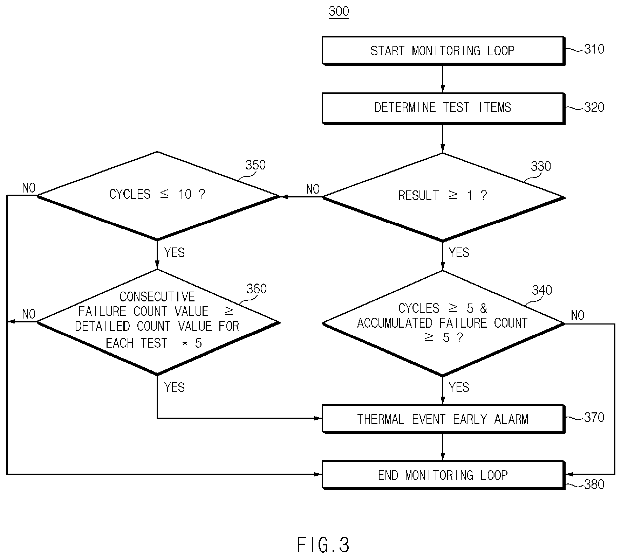

FIG. 3 may illustrate a process of performing an early alarm for a thermal event through a first diagnosis and a second diagnosis according to some embodiments.

Referring to FIG. 3, a flowchart 300 may be illustrated showing a process of performing an early alarm for a thermal event through a first diagnosis and a second diagnosis. The flowchart 300 may include steps 310 to 380.

In step 310, a monitoring loop for the diagnosis target battery 120 may be started. For example, the monitoring loop may respond to driving of an electric vehicle and respond to a current cycle. In step 320, a determination as to whether the test items pass may be made. In step 330, a determination as to whether there is a result that even one item (result ≥ 1) fails or not (result < 1) may be made. In step 340, a determination as to whether the accumulated value of the failure count is 5 or more for 5 or more cycles may be made, and when YES, a thermal event early alarm may be performed in step 370, and when NO, the monitoring loop may end by proceeding to step 380. Consecutive failure count may refer to an accumulated failure count.

In step 350, when there is no failed test item, a determination as to whether 10 cycles (the second number of cycles) have elapsed may be made. When elapsed (NO), the monitoring loop may end in step 380. When not elapsed (YES), the consecutive failure count value in step 360 may be compared with the second diagnosis threshold. The second diagnosis threshold may be calculated as (the detailed count value for each test * five times). This may be intended to consider the risk of overheating due to data collection failure in relation to the second diagnosis. When YES, the thermal event early alarm may be performed in step 370, and when NO, the monitoring loop may end in step 380.

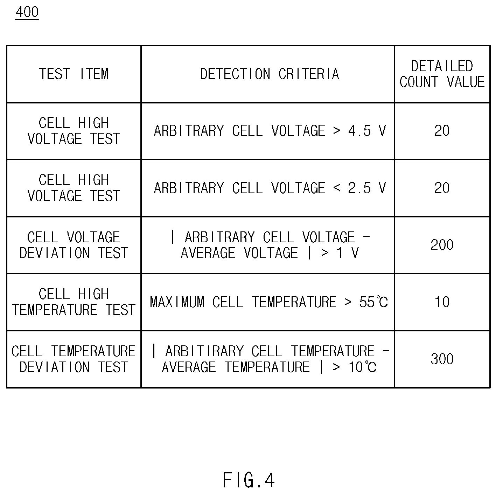

FIG. 4 may illustrate detection criteria and detailed count values of test items according to some embodiments.

Referring to FIG. 4, a graph 400 illustrating detection criteria and detailed count values of test items may be illustrated.

The graph 400 may display five test items. The five test items may be a cell high voltage test, a cell low voltage test, a cell voltage deviation test, a cell high temperature test, and a cell temperature deviation test.

The graph 400 may display detection criteria for the five test items. For example, in the case of the cell high voltage test, a determination as to whether there is a battery cell having a cell voltage exceeding 4.5 V among a plurality of battery cells may be made. In a similar manner, the remaining four test items may be determined.

The graph 400 may display detailed count values for the five test items. For example, in the case of the cell high voltage test, the number of occurrence of any battery cell exceeding 4.5 V at each collection interval (e.g., one second) may be counted in the current cycle (e.g., 30-minute driving time of the electric vehicle). When the count value of the cell high voltage test in the current cycle exceeds the detailed count value of 20, the cell high voltage test may be checked as defective.

Meanwhile, the cell voltage deviation test and cell temperature deviation test may have relatively high detailed count values due to the nature of the tests. The numerical values and detailed count values of the detection criteria exemplified in the graph 400 may be changed to other appropriate values depending on the design.

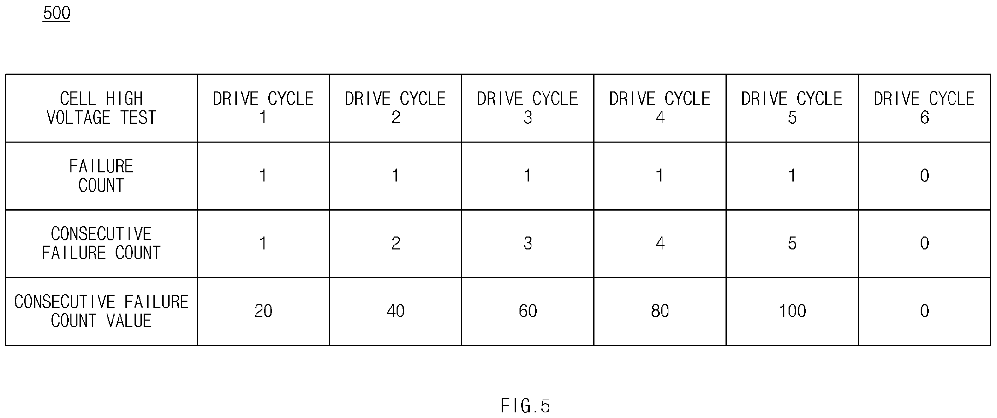

FIG. 5 may illustrate a form in which count values for a cell high voltage test change as cycles progress according to some embodiments.

A graph 500 illustrating a form in which count values for a cell high voltage test change as cycles progress may be illustrated.

A third row of the graph 500 may represent a consecutive failure count value, which may mean an accumulated failure count. A fourth row of the graph 500 may represent a consecutive failure count value, which may mean an accumulated value of the first count value (e.g., the detailed count value of the graph 400).

The graph 500 may exemplarily display only the cell high voltage test among five test items. Since the cell high voltage test fails in all five cycles (drive cycles 1 to 5), the accumulated failure count in drive cycle 5 may be five. This may satisfy the criteria of the first diagnosis for the diagnosis target battery 120, and may indicate that the diagnosis target battery 120 currently is at the risk of overheating.

The graph 500 may display the accumulation of the first count value in the lowest row. When accumulated failure count is less than 5 in drive cycle 5, the first diagnosis may not be performed. In this case, when the number of times battery data collection fails during 10 cycles (the second number of cycles) exceeds 100 (20*5), the battery may be subject to the second diagnosis. In this way, even when the risk is low from the perspective of the first diagnosis, the risk due to data collection failure may be analyzed through the second diagnosis.

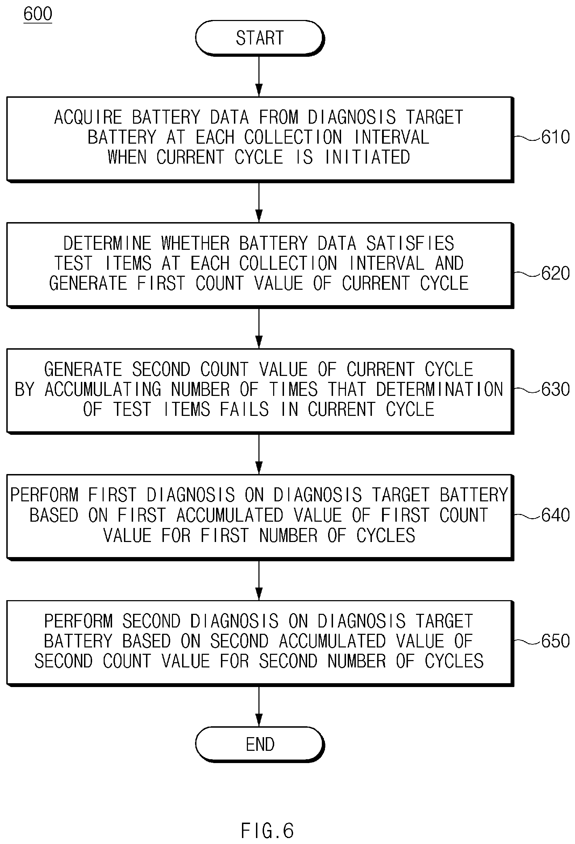

FIG. 6 may illustrate steps of a battery diagnosis method according to some embodiments.

Referring to FIG. 6, a battery diagnosis method 600 may include steps 610 to 650. However, the battery diagnosis method is not limited thereto, and some steps may be omitted or other general steps may be added, and the steps of the battery diagnosis method 600 may be executed in a different order than the illustrated order.

The battery diagnosis method 600 may include steps that are processed in time series in the battery diagnosis device 130. Therefore, even when the content is omitted below, the content described above for the battery diagnosis device 130 may be equally applied to the battery diagnosis method 600.

Steps 610 to 650 of the battery diagnosis method 600 may be performed by the interface 131 and the controller 132 of the battery diagnosis device 130.

In step 610, the battery diagnosis device 130 may perform a step of acquiring battery data from a diagnosis target battery at each collection interval when a current cycle is initiated.

In step 620, the battery diagnosis device 130 may perform a step of determining whether the battery data passes test items at each collection interval and generating a first count value of the current cycle.

In step 630, the battery diagnosis device 130 may perform a step of generating a second count value of the current cycle by accumulating the number of times that the determination of the test items fails in the current cycle.

In step 640, the battery diagnosis device 130 may perform a step of performing a first diagnosis on the diagnosis target battery based on the first accumulated value of the first count value for the first number of cycles.

In step 650, the battery diagnosis device 130 may perform a step of performing a second diagnosis on the diagnosis target battery based on a second accumulated value of the second count value for the second number of cycles.

According to an embodiment, the battery diagnosis method 600 may be implemented in the form of a computer program stored in a computer-readable storage medium. That is, the computer program may include commands for implementing the battery diagnosis method 600, and the commands of the program may be stored in the computer-readable storage medium. The computer program may include a mobile application.

In an embodiment, a computer-readable storage medium may include magnetic media such as hard disks, floppy disks, and magnetic tapes, optical media such as CD-ROMs and DVDs, magneto-optical media such as floptical disks, and a hardware device specially configured to store and execute computer program instructions, such as ROM, RAM, flash memory, or the like. Computer program instructions may include machine language code generated by a compiler and high-level language code that may be executed by a computer using an interpreter, or the like.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

### (Reference Signs List)

| | | | |
|---|---|---|---|
| 100: | Battery diagnosis system | 110: | Electric power device |
| 120: | Diagnosis target battery | 130: | Battery diagnosis device |
| 131: | Sensor | 132: | Controller |

## Claims

1. A battery diagnosis device comprising:
an interface configured to acquire battery data from a diagnosis target battery for each collection interval when a current cycle is initiated; and
a controller configured to:
determine whether the battery data passes test items for each collection interval and generate a first count value of the current cycle;
accumulate a number of times the determination of the test items fails in the current cycle and generate a second count value of the current cycle;
perform a first diagnosis on the diagnosis target battery based on a first accumulated value of the first count value for a first number of cycles; and
perform a second diagnosis on the diagnosis target battery based on a second accumulated value of the second count value for a second number of cycles.

2. The battery diagnosis device of claim 1, wherein the diagnosis target battery includes a plurality of battery cells, and
the battery data includes a cell voltage and a cell temperature of each of the plurality of battery cells.

3. The battery diagnosis device of claim 2, wherein the test items include a first item regarding whether a maximum cell voltage exceeds a cell voltage upper limit, a second item regarding whether a minimum cell voltage is less than a cell voltage lower limit, a third item regarding whether a cell voltage deviation with respect to an average cell voltage exceeds a voltage deviation threshold, a fourth item regarding whether a maximum cell temperature exceeds a cell temperature upper limit, and a fifth item regarding whether a cell temperature deviation with respect to an average cell temperature exceeds a temperature deviation threshold.

4. The battery diagnosis device of claim 1, wherein the controller is configured to:
determine a detailed count value for each of the test items for each collection interval;
check, among the test items, a test item whose detailed count value exceeds a threshold count of each of the test items as defective in the current cycle; and
perform the first diagnosis based on the number of defects of the test items for the first number of cycles up to the current cycle.

5. The battery diagnosis device of claim 4, wherein the controller is configured to perform the first diagnosis when there is a test item that is checked as defective in all of the first number of cycles among the test items.

6. The battery diagnosis device of claim 4, wherein the controller is configured to perform the second diagnosis when the second accumulated value of the second count value for the second number of cycles exceeds a second diagnosis threshold of each of the test items.

7. The battery diagnosis device of claim 6, wherein the second number of cycles is greater than the first number of cycles and the second diagnosis threshold of each of the test items is a product of the threshold count of each of the test items and the first number of cycles.

8. The battery diagnosis device of claim 1, wherein the controller is configured to change a state of the diagnosis target battery to a thermal event early alarm state based on at least one of the first diagnosis and the second diagnosis.

9. A battery diagnosis method comprising:
acquiring battery data from a diagnosis target battery for each collection interval when a current cycle is initiated;
determining whether the battery data passes test items for each collection interval and generating a first count value of the current cycle;
accumulating a number of times the determination of the test items fails in the current cycle and generating a second count value of the current cycle;
performing a first diagnosis on the diagnosis target battery based on a first accumulated value of the first count value for a first number of cycles; and
performing a second diagnosis on the diagnosis target battery based on a second accumulated value of the second count value for a second number of cycles.

10. The battery diagnosis method of claim 9, wherein the diagnosis target battery includes a plurality of battery cells, and
the battery data includes a cell voltage and a cell temperature of each of the plurality of battery cells.

11. The battery diagnosis method of claim 10, wherein the test items include a first item regarding whether a maximum cell voltage exceeds a cell voltage upper limit, a second item regarding whether a minimum cell voltage is less than a cell voltage lower limit, a third item regarding whether a cell voltage deviation with respect to an average cell voltage exceeds a voltage deviation threshold, a fourth item regarding whether a maximum cell temperature exceeds a cell temperature upper limit, and a fifth item regarding whether a cell temperature deviation with respect to an average cell temperature exceeds a temperature deviation threshold.

12. The battery diagnosis method of claim 9, wherein the performing of the first diagnosis includes:
determining a detailed count value for each of the test items for each collection interval;
checking, among the test items, a test item whose detailed count value exceeds a threshold count of each of the test items as defective in the current cycle; and
performing the first diagnosis based on the number of defects of the test items for the first number of cycles up to the current cycle.

13. The battery diagnosis method of claim 12, wherein the performing of the first diagnosis includes performing the first diagnosis when there is a test item that is checked as defective in all of the first number of cycles among the test items.

14. The battery diagnosis method of claim 12, wherein the performing of the second diagnosis includes performing the second diagnosis when the second accumulated value of the second count value for the second number of cycles exceeds a second diagnosis threshold of each of the test items.

15. The battery diagnosis method of claim 14, wherein the second number of cycles is greater than the first number of cycles and the second diagnosis threshold of each of the test items is a product of the threshold count of each of the test items and the first number of cycles.

16. The battery diagnosis method of claim 9, further comprising changing a state of the diagnosis target battery to a thermal event early alarm state based on at least one of the first diagnosis and the second diagnosis.
